# EUROPÄISCHE PATENTSCHRIFT

(11) **EP 0 498 909 B1**
(45) Veröffentlichungstag und Bekanntmachung des Hinweises auf die Patenterteilung: **04.08.1993**
(21) Anmeldenummer: 91102026.1
(22) Anmeldetag: 13.02.1991
(51) Int. Cl.: G01R 35/04

(54) **Tarifgerät zur kontinuierlichen Erfassung und Anzeige der während konstanter Zeitintervalle gemittelten Grössen der von einem Verbraucher dem Netz entnommenen elektrischen Verbrauchswerte**
Electricity meter with tariff switching for the continuous acquisition and display of the amount of mains power, averaged over constant time intervals, used by a consumer
Compteur à plusieurs tarifs pour l'acquisition et l'affichage continus de données de puissance d'un consommateur au secteur, données dont la moyenne est formée sur des périodes constantes

(43) Veröffentlichungstag der Anmeldung: 19.08.1992
(73) Patentinhaber: SIEMENS AKTIENGESELLSCHAFT, 80333 München (DE)
(72) Erfinder: Schwendtner, Manfred Dipl.-Ing., W-8501 Schwarzenbruck (DE); Steinmüller, Günter Dipl.-Ing. (FH), W-8500 Nürnberg (DE)

(56) Entgegenhaltungen:
- EP-A- 0 240 102
- US-A- 4 598 248
- US-A- 4 600 881

## Beschreibung

Die Erfindung betrifft ein Tarifgerät nach dem Oberbegriff des Patentanspruches 1.

Ein Tarifgerät dieser Art als sogenanntes Maximumwerk mit gleitender Meßperiode ist beispielsweise aus der DE-PS 24 46 602 bekannt. Dieses Tarifgerät ist aus elektronischen Bauelementen aufgebaut und es besitzt einen Ringspeicher in Form eines Schieberegisters, in welches in bestimmten Zeitabständen ermittelte Verbrauchswerte eingegeben, dort von Speicherplatz zu Speicherplatz weitergegeben und nach Durchlaufen sämtlicher Speicherplätze wieder ausgeschieden werden. Über den jeweiligen Speicherinhalt des Schieberegisters wird ein Mittelwert gebildet, der ein Maß ist für den tatsächlichen mittleren Verbrauch an elektrischer Energie über die Speicherzeitspanne.

Bei Elektrizitätszählern dieser Art hat sich ein Standard herausgebildet, bei dem das Schieberegister in einem 60-Minuten-Takt über eine Meßperiode von 96 Stunden fortgeschaltet wird. Dabei läuft das interne Zeitraster asynchron zu der astronomischen Zeit, beginnend mit jedem Rückstellzeitpunkt. Die Funktionsprüfung eines solchen Tarifgerätes erfordert einen erheblichen Zeitaufwand. Eine Verkürzung der Prüfprozedur durch einen Eingriff in die Schaltung des Tarifgerätes ist nicht möglich, weil die Prüfung auch am betriebsfähigen, plombierten Gerät durchführbar sein soll. Bei einer kompletten Prüfung über beispielsweise zwei Meßperioden von je 96 Stunden nimmt der Prüfvorgang insgesamt 8 x 24 Stunden in Anspruch.

Der Erfindung liegt die Aufgabe zugrunde, eine wesentliche Verkürzung der Dauer des Prüfvorganges zu erreichen. Diese Aufgabe wird durch die im Patentanspruch 1 angegebene Erfindung gelöst.

Dadurch ist erreicht, daß durch einen einfachen Bedienungsvorgang am plombierten Gerät, also ohne Eingriff in die Hardware, eine Reduzierung der insgesamt erforderlichen Meßzeit von beispielsweise 2 x 96 Stunden auf 2 x 96 Minuten möglich ist.

In einer Weiterbildung der Erfindung gemäß Patentanspruch 3 läßt sich der Prüfvorgang ohne zusätzlichen Schaltungsaufwand durch eine kombinierte Betätigung von wenigstens zwei vorhandenen Tasten, beispielsweise der Rückstelltaste bei gleichzeitigem Einschalten der Netzspannung, auslösen.

Weitere Einzelheiten der Erfindung werden im folgenden Ausführungsbeispiel beschrieben.

Das Tarifgerät 1 besteht aus einem Mikrocomputer 2 mit Programm- und Arbeitsspeicher, einer LCD-Anzeige 3 sowie einem Netzanschlußgerät 4 mit einer Spannungsüberwachungsstufe 5. Dem Mikrocomputer sind eingangsseitig ein Impulsgeber 6, eine Steuersignalstufe 7, eine Rückstelltaste 8 sowie eine Aufruftaste 9 und ausgangsseitig eine Impulsausgangsstufe 10 sowie eine Steuerausgangsstufe 11 zugeordnet. Darüber hinaus besitzt der Mikrocomputer einen nichtflüchtigen Speicher 12 und eine optische Datenschnittstelle 13.

Die Impulsgeberstufe 6 ist mit zwei Fotosensoren 14, 15 in Form von Miniatur-Reflexlichtschranken ausgestattet, die auf der Läuferscheibe 16 eines nicht dargestellten Induktionszählers aufgedruckte vier schwarze Marken 17, 18 abtasten. Die Fotosensoren 14, 15 sind so angeordnet, daß bei Drehung der Läuferscheibe 16 phasenverschobene Impulszüge an den Mikrocomputer geliefert werden. Dieser erkennt dabei die Umdrehungsrichtung und gibt Impulse bei der Vorwärtsdrehrichtung der Läuferscheibe in das Rechenwerk des Mikrocomputers 2 ein, unterdrückt aber die bei einer möglichen Rückwärtsdrehung auftretenden Impulse.

Das Rückwärtsdrehen kann in bekannter Weise auch durch eine Rücklaufsperre im Induktionszähler mechanisch unterbunden werden. Fehlmessungen durch mögliche Pendelbewegungen der Läuferscheibe bis um ca. 18 Winkelgrade werden durch das vorgenannte Verfahren ebenfalls verhindert.

Der mit einem Zeitgeber für die Erzeugung einer Zeittaktfrequenz (f_{Z}) ausgestattete Mikrocomputer 2 erhält seine Basisinformation zur Ermittlung der Arbeits/Leistungswerte von der Impulsgeberstufe 6. Diese werden im nichtflüchtigen Speicher 12 abgespeichert. Der Mikrocomputer erzeugt mit Hilfe seines Zeitgebers Setzimpulse mit konstanter Taktfrequenz im Einstundenrhythmus (1h-Raster) sowie Rücksetzimpulse nach Ablauf einer Meßperiode von beispielsweise 96 Stunden. Dabei können für Prüfzwecke die Impulse für das 1h-Raster sowie die Impulse für die Meßperiode durch Eingabe in die Steuersignalstufe 7 auch extern synchronisiert werden. Die Rückstellung kann dabei wahlweise zu einem beliebigen Zeitpunkt durch eine berechtigte Person von Hand über die plombierte Rückstelltaste 8 oder durch Fernsteuerung über einen Rundsteuerempfänger 19 ausgelöst werden. Eine weitere Möglichkeit der Rückstellung besteht über die optische Datenschnittstelle 13. Der Zugriff ist über ein Paßwort oder einen anderen Verschlüsselungsalgorithmus in gesicherter Weise möglich.

Der Mikrocomputer bearbeitet die zugeführten Daten in der Weise, daß er nach einer Bewertung der Zählimpulse der Impulsgeberstufe die elektrischen Arbeit- und Leistungswerte ermittelt, diese Werte im nichtflüchtigen Speicher 12 ablegt, die von der Steuerstufe 7 zugeführten Steuersignale für die Synchronisierung des 1h-Rasters sowie die Tarifumschaltung und die Höchstwertbildung auswertet, die Zeitbasis für die Meßperioden des 1h-Rasters bildet und die Rückstellung veranlaßt, darüber hinaus die Meßperiode steuert, die Tarifinformation verarbeitet, die Daten im nichtflüchtigen Speicher 12 bei Unterbrechung der Versorgungsspannung sichert und die Meßwerte auf der LCD-Anzeige 3 anzeigt. Dazu wird der Anzeigeabruf über die Aufruftaste 9 oder über die optische Datenschnittstelle 13, beispielsweise durch einen Lichtstrahl einer Taschenlampe, gesteuert. Dabei können folgende Meßwerte gebildet werden:
Arbeitswerte in mehreren Tarifen und die Summe dieser Werte;
Einstunden-Verbrauchswerte der letzten 96 Stunden in Abhängigkeit vom Tarif;
zu jeder Stunde der Verbrauch über die letzten 96 Stunden;
der Leistungs-Höchstwert über jeweils eine Verrechnungsperiode;
der Leistungs-Höchstwert über eine Anzahl von Verrechnungsperioden sowie weitere den Verbraucher oder das Elektrizitätsversorgungsunternehmen interessierende Werte.

Alle diese Werte sind auf der LCD-Anzeige 3 darstellbar.

Darüber hinaus besteht die Möglichkeit, durch Betätigen der Aufruftaste 9 weitere gespeicherte Daten, z.B. die Anzahl der Rückstellungen, in einer festgelegten Reihenfolge anzuzeigen. Falls die Aufruftaste 9 während einer bestimmten Zeitperiode nicht betätigt wird, können automatisch zyklisch wiederkehrende verschiedene Meßwerte auf der LCD-Anzeige 3 dargestellt werden.

Um nun die Prüfzeit über eine komplette Meßperiode von im vorliegenden Fall 96 Stunden ohne Eingriff in das plombierte Gerät erheblich verkürzen zu können, wird die Zeittaktfrequenz f_{Z} der Setzimpulse des im Mikroprozessor vorhandenen Impulsfrequenzerzeugers um einen Faktor x vervielfacht. Das Auslösen dieser Taktfrequenzerhöhung während des Prüfvorganges kann in der Weise geschehen, daß eine in den Mikrocomputer einsteckbare Prüftaste 20 betätigt wird. Eine weitere Möglichkeit der Betätigung besteht darin, daß zwei vorhandene Tasten, beispielsweise die Rückstelltaste 8 und die Aufruftaste 9, gleichzeitig betätigt werden.

Der Mikrocomputer verarbeitet die ihm zugeführten Daten in der Weise, daß er nach einer Bewertung der Zählimpulse der Impulsgeberstufe die elektrischen Arbeits/Leitungswerte ermittelt und zwischenspeichert; die von der Steuerstufe 7 zugeführten Steuersignale für die Synchronisierung des 1h-Rasters, die Tarifumschaltung und die Höchstwertbildung auswertet; die Zeitbasis für die Meßperiodensteuerung und des 1h-Rasters bildet, die Fortschaltung im 1h-Rhythmus und die Rückstellung nach jeder Meßperiode veranlaßt, die Tarifinformationen verarbeitet, die Daten in den nichtflüchtigen Speicher 12 eingibt und bei Unterbrechung der Versorgungsspannung sichert und schließlich die ermittelten Meßwerte im Klartext auf der LC-Anzeige 3 anzeigt. Dabei wird der Anzeigeabruf über die Aufruftaste 9 oder die optische Datenschnittstelle 13, beispielsweise durch einen Lichtstrahl einer Taschenlampe, gesteuert. Die codierte Information wird über die Impulsausgangsstufe 10 oder die optische Datenschnittstelle 13 ausgegeben. Mit Hilfe der Steuerausgangsstufe 11 können einzelne Verbraucher je nach Tarif und/oder Verbrauch entsprechend den vorgegebenen Werten zu- oder abgeschaltet werden.

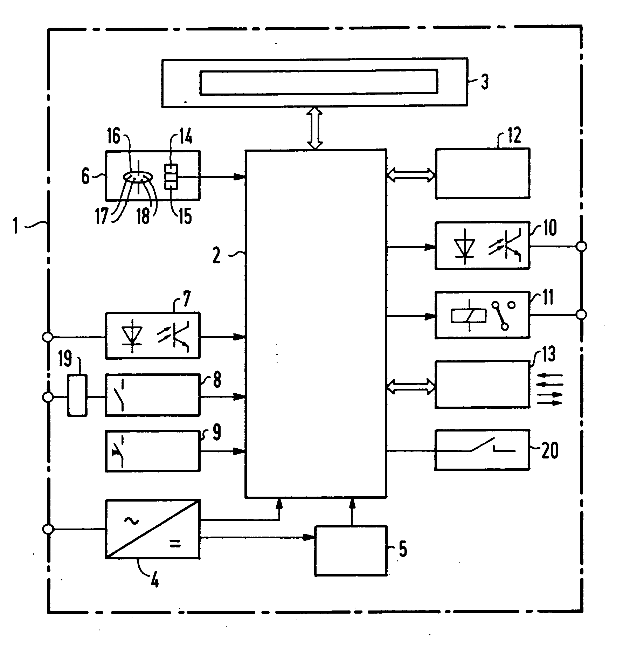

## Patentansprüche

1. Tarifgerät (1) zur kontinuierlichen Erfassung und Anzeige der während konstanter, im Takt eines n-Stunden-Zeitrasters mit der Zeittaktfrequenz f_{Z} fortschreitender Zeitintervalle gemittelten Größen der von einem Verbraucher dem Netz entnommenen elektrischen Verbrauchswerte, bestehend aus einem Mikrocomputer (2) mit einem Programm- und Arbeitsspeicher sowie einem Zeitgeber für die Erzeugung der Zeittaktfrequenz f_{Z} und einem Rechenwerk für die digitale Mittelwertbildung, dem ein nichtflüchtiger externer Arbeitsspeicher (12), eine LCD-Anzeige (3), ein Netzanschlußgerät (4) mit Spannungsüberwachungsstufe (5), ein Impulsgeber (6), dessen Impulse pro Zeiteinheit ein Maß für die gemessene elektrische Leistung und, multipliziert mit der Zeit, ein Maß für die entnommene elektrische Energie sind, eine Steuerstufe (7) für die Synchronisierung der Arbeitstarifsteuerung, eine Rückstelltaste (8; 19) sowie eine Aufruftaste (9) für die Darstellung gespeicherter Daten auf der LCD-Anzeige (3) in festgelegter Reihenfolge zugeordnet sind, **dadurch gekennzeichnet,** daß die betriebsmäßige Zeittaktfrequenz f_{Z} des Zeittaktgebers des Mikrocomputers (2) während der Prüfperiode des Tarifgerätes (1) durch wenigstens eine von Hand betätigbare Prüftaste (20) um einen Faktor (x) vervielfacht ist.

2. Tarifgerät (1) nach Anspruch 1, **dadurch gekennzeichnet,** daß die betriebsmäßige Zeittaktfrequenz f_{Z} von einem Impuls pro Stunde während der Prüfperiode auf einen Impuls pro Minute vervielfacht ist.

3. Tarifgerät (1) nach Anspruch 1 oder 2, **dadurch gekennzeichnet,** daß der Umschaltvorgang für die Vervielfachung der Zeittaktfrequenz f_{Z} durch die kombinierte Betätigung von wenigstens zwei vorhandenen Tasten (8, 9) ausgelöst ist.

## Claims

1. Tariff unit (1) for continuously detecting and displaying the magnitudes of the consumption values of electricity drawn from the mains by a consumer, which magnitudes are averaged over constant time intervals progressing in time with an n-hour time slot pattern with clock frequency f_{Z}, consisting of a microcomputer (2) with a program memory and main memory and also a timer for the generation of the clock frequency f_{Z} and an arithmetic unit for the digital mean-value generation, with which there are associated in fixed sequence a non-volatile, external main memory (12), an LCD display (3), a mains connection unit (4) with voltage-monitoring stage (5), a pulse transmitter (6), the pulses of which, per unit of time, are a measure of the measured electrical power and, multiplied by the time, a measure of the electrical energy drawn, a control stage (7) for the synchronization of the energy tariff control, a reset button (8; 19) and also a call button (9) for the representation of stored data on the LCD display (3), characterised in that the operational clock frequency f_{Z} of the timer of the microcomputer (2) is multiplied by a factor (x) during the testing period of the tariff unit (1) by means of at least one test button (20) which can be actuated by hand.

2. Tariff unit (1) according to claim 1, characterised in that the operational clock frequency f_{Z} of one pulse per hour is multiplied during the testing period to one pulse per minute.

3. Tariff unit (1) according to claim 1 or 2, characterised in that the change-over operation for the multiplication of the clock frequency f_{Z} is triggered by the combined actuation of at least two buttons (8, 9) which are present.

## Revendications

1. Compteur (1) à tarifs multiples pour la détermination et l'affichage continus des grandeurs, dont la moyenne est formée pendant un intervalle de temps constant qui se déroule à la cadence d'une trame temporelle de n heures à la fréquence de cadence temporelle f_{Z}, des valeurs de consommation électrique prélevées du réseau par un abonné, constitué par un micro-ordinateur (2) comportant une mémoire de programme et de travail ainsi qu'un générateur de base de temps pour produire la fréquence de cadence temporelle f_{Z} et une unité de calcul pour la formation de la moyenne numérique et à laquelle sont associés une mémoire de travail extérieure non volatile (12), un dispositif d'affichage LCD (3), un appareil (4) de raccordement au réseau comportant un étage (5) de contrôle de la tension, un générateur d'impulsions (6), dont les impulsions par unité de temps représentent une mesure de la puissance électrique mesurée et, multipliée par le temps, une mesure de l'énergie électrique prélevée, une unité de commande (7) pour la synchonisation de l'unité de commande des tarifs de travail, une touche de rappel (8;19) ainsi qu'une touche d'appel (9) pour la représentation de données mémorisées sur le dispositif d'affichage LCD (3) selon une séquence fixée, caractérisé par le fait que la fréquence de cadence temporelle en fonctionnement f_{Z} du générateur de cadence temporelle du micro-ordinateur (2) est multipliée d'un facteur (x) à l'aide d'au moins une touche de contrôle (20) pouvant être actionnée manuellement, pendant la période de contrôle de l'appareil (1) à tarifs multiples.

2. Compteur (1) à tarifs multiples suivant la revendication 1, caractérisé par le fait que la fréquence de cadence temporelle en fonctionnement f_{Z} est multipliée par une impulsion par heure pour fournir une impulsion par minute pendant la période de contrôle.

3. Compteur (1) à tarifs multiples suivant la revendication 1 ou 2, caractérisé par le fait que le processus de commutation pour la multiplication de la fréquence de cadence temporelle f_{Z} est déclenché au moyen de l'actionnement combiné d'au moins deux touches (8,9) présentes.
